# EUROPEAN PATENT APPLICATION

(11) **EP 1 191 610 A2**
(43) Date of publication of application: **27.03.2002**
(21) Application number: 01122889.7
(22) Date of filing: 24.09.2001
(51) Int. Cl.: H01L 41/053, H01L 41/09

(54) **System for connecting a piezoelectric actuator to a rigid supporting base**

(30) Priority: 22.09.2000 IT TO000889
(71) Applicant: MATRIX S.p.A., I-10015 Ivrea (IT)
(72) Inventor: Gaiardo, Mario, 10015 Ivrea (IT); Leone, Diego, 14049 Nizza Monferrato (IT); Glauda, Roberto, 10010 Albiano D'Ivrea (IT)
(74) Representative: Cerbaro, Elena, Dr.

(57) **Abstract**

The actuator (5) has a central electrode (6) to which two layers of ceramic material (9, 11) are fixed, and two lateral electrodes (12, 13) fixed to the layers of ceramic material (9, 11). The connecting system includes a connection (22) of a portion (17) of the actuator (5) to the base (23), and electric connections (33, 39, 41, 66 and 70) of the electrodes (6, 12, 13) to corresponding pins (34, 42, 43; 42', 43'). At least one of the connections (22; 33, 39, 41; 66, 70) is flexible to reduce mechanical stress on the layers of ceramic material (9, 11) at the connection. The connection (22) may be defined by two hinges (53, 54), or by a hinge (53) and a slide (59), or by two pairs of bearings (62, 63) of flexible material. The electric connection (66) is formed by welding the relative pin (34) to an elastic tongue (68) of the central electrode (6). Each of the electric connections (70) is obtained by interposing, between each lateral electrode (12, 13) and the corresponding pin (42', 43'), a bar (72) made of conducting material and having a coil-shaped portion (82).

## Description

The present invention relates to a system for connecting a piezoelectric actuator to a rigid supporting base; the actuator comprising a metal layer forming a central electrode and having two opposite surfaces, two layers of ceramic material fixed to the two surfaces, and two lateral electrodes fixed to the layers of ceramic material. Actuators of the above type are used in various selection or control devices, in industrial automation technology in general, and particularly in digital or analog selectors of pneumatic devices, textile machines, etc.

Piezoelectric actuators are substantially rectangular, and normally comprise a first-end portion connected rigidly to a supporting base. The first-end portion comprises a region of the central electrode having a first electric connection to a corresponding central pin; and each of the two lateral electrodes has a corresponding second electric connection to a corresponding lateral pin. Both the first electric connection and each of the second electric connections are located in the first-end portion of the actuator; and, by selectively exciting the above electrodes, the layers of ceramic material flex accordingly to selectively move a second end of the actuator.

In known technology, the piezoelectric actuator is fixed rigidly to the base, normally by inserting the first-end portion inside a seat on the base, and embedding it in a resin to form a rigid connection, so that the actuator functions in the same way as a beam fixed at one end. Since the two layers of ceramic material are flexed at each excitation, the fixed end generates a reaction to flexing of the ceramic layers; and, the actuator electrodes normally being connected electrically to the pins by welding, further rigid constraints, and hence further reactions, are generated which also oppose flexing of the ceramic layers.

All these reactions generate stress in the ceramic crystal structure, which results in rapid failure of the ceramic layer and greatly reduces the working life of the actuator, so that, to simplify replacement of damaged actuators, each is preferably fixed to a separate base of its own. It has also been observed that the larger the crystals are, the more fragile the ceramic is. So attempts have been made to reduce failure of the actuators by producing ceramics with a very fine, and therefore high-cost, crystal structure. In actual use, however, the failure rate of actuators of this type still remains extremely high.

It is an object of the present invention to provide a system for connecting a piezoelectric actuator, wherein the failure rate of the ceramic layers is greatly reduced, and which provides for achieving a highly reliable, low-cost actuator by eliminating the drawbacks typically associated with known actuators.

According to the present invention, there is provided a system for connecting a piezoelectric actuator to a rigid supporting base, wherein the actuator comprises a central electrode having two opposite surfaces, two layers of piezoelectric ceramic material fixed to said two surfaces, and two lateral electrodes fixed to said layers of ceramic material; comprising a connection of said base to a portion of said actuator, said portion including a region of said central electrode having a first electric connection to a central pin, and each of said lateral electrodes having a second electric connection to a corresponding lateral pin; characterized in that at least one connection of said connections is flexible to reduce mechanical stress on said layers of ceramic material at said at least one connection.

A number of preferred embodiments of the connecting system will be described by way of example with reference to the accompanying drawings, in which:
Figure 1 shows a partly sectioned front view of a piezoelectric actuator to which the connecting system according to the invention refers;
Figure 2 shows a larger-scale, partial section along line II-II in Figure 1;
Figure 3 shows a connection according to the prior art;
Figure 4 shows a partial front view of the Figure 1 actuator connected to a supporting base as in Figure 3;
Figure 5 shows four sections along lines A-A, B-B, C-C and D-D in Figure 4;
Figure 6 shows a connection according to a first embodiment of the invention;
Figure 7 shows a partial front view of the Figure 1 actuator connected to a supporting base as in Figure 6;
Figure 8 shows four sections along lines A-A, B-B, C-C and D-D in Figure 7;
Figure 9 shows a connection according to a further embodiment of the invention;
Figure 10 shows a partial front view of the Figure 1 actuator connected to a supporting base as in Figure 9;
Figure 11 shows four sections along lines A-A, B-B, C-C and D-D in Figure 10;
Figure 12 shows a connection according to a further embodiment of the invention;
Figure 13 shows a partial front view of a variation of the Figure 1 actuator connected to a supporting base as in Figure 12;
Figure 14 shows four sections along lines A-A, B-B, C-C and D-D in Figure 13;
Figure 15 shows a performance graph of the actuator connected as in Figures 3, 6, 9 and 12.

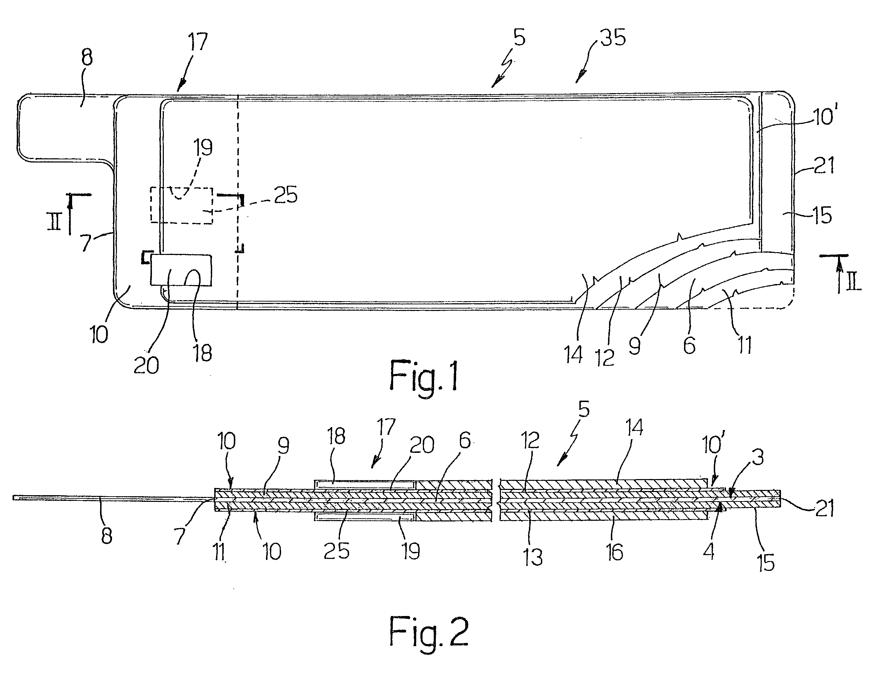

Number 5 in Figures 1 and 2 indicates as a whole a piezoelectric actuator for a selection device. Actuator 5 comprises a substantially rectangular, central metal plate of about 0.1 mm in thickness, and which defines the central electrode 6 of actuator 5 and has, at a first end 7, a region in the form of an appendix 8 defining a contact for electric connection of central electrode 6. Electrode 6 has two opposite surfaces 3 and 4, to which are fixed, e.g. glued, two layers 9 and 11 of ceramic, e.g. bimorph piezoelectric, material. Each layer 9, 11 is about 0.25 mm thick, is rectangular, leaving appendix 8 exposed, and, when excited electrically, flexes to deform central electrode 6.

The outer surface of each layer 9, 11 is coated with a very thin metal layer obtained, for example, by vapor depositing nickel of a few microns in thickness. Each metal layer leaves exposed a strip 15 of ceramic layer 9, 11 adjacent to an end 21 of actuator 5 opposite end 7. Each metal layer defines a lateral electrode 12, 13 of actuator 5, and is covered with a film 14, 16 of insulating material. Each film 14, 16 leaves exposed two end strips 10, 10' of respective lateral electrode 12, 13. In a portion 17 of actuator 5 adjacent to end 7, each film 14, 16 of insulating material has a rectangular window 18, 19 defining, on lateral electrode 12, 13, a respective contact 20, 25 for the electric connection of respective lateral electrode 12, 13 of actuator 5. The strip 15 of ceramic layer 9, 11 not covered by lateral electrode 12, 13 is normally connected to a selection element not shown.

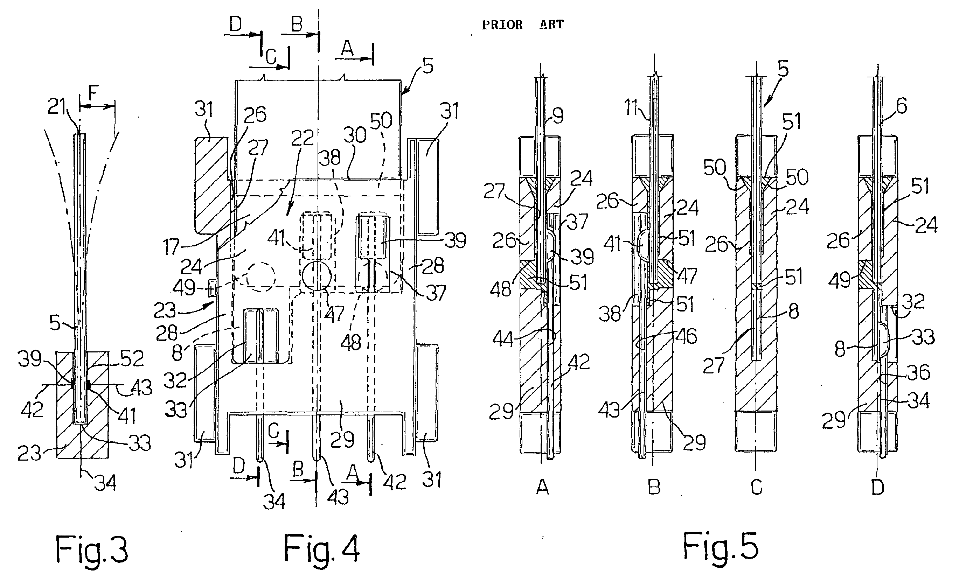

Actuator 5 is fitted to a rigid support, indicated as a whole by 23 (Figure 4), by means of a connection 22. Base 23 is normally made of molded plastic, and comprises two walls 24 and 26 (see also Figure 5) separated by a slit or gap 27 for housing portion 17 of actuator 5 and appendix 8 of central electrode 6, so that portion 17 represents the connecting portion of actuator 5 for connection to base 23. Walls 24 and 26 are connected to each other by two lateral edges 28 and by a bottom portion 29, and terminate in respective edges 30 defining the end of connecting portion 17 as indicated by a dash line in Figure 1. Actuator 5 comprises a freely flexible deflecting portion 35 extending between portion 17 and end 21; and each lateral edge 28 (Figure 4) has two integral appendixes 31 for positioning base 23 in a fastening frame not shown.

Wall 24 has a first rectangular window 32 permitting a first electric connection 33 (Figure 5D) of appendix 8 of central electrode 6 to a corresponding central pin 34 inserted inside a hole 36 in bottom portion 29; and each wall 24, 26 has a rectangular window 37, 38 permitting a second electric connection 39, 41 (Figures 5A, 5B) of contact 20, 25 of respective lateral electrode 12, 13 to a corresponding lateral pin 42, 43 inserted inside a respective hole 44, 46 in bottom portion 29.

Each wall 24, 26 has a circular opening 47, 48 normally located at window 38, 37 in the opposite wall 26, 24; wall 26 has a further circular opening 49 aligned transversely with openings 47 and 48 and located longitudinally at window 32 in wall 24; each wall 24, 26 has an inner bevel 50 at respective edge 30 for assisting insertion of portion 17 of actuator 5 inside gap 27 in base 23; and openings 47, 48, 49 and bevels 50 also permit the insertion of connecting material inside gap 27, between portion 17 of actuator 5 and walls 24 and 26 of base 23.

In the known technique, a connecting material defined by a bicomponent epoxy resin 51 is inserted through openings 47-49 and bevels 50 into gap 27, is normally very liquid to completely fill all the spaces in gap 27 on both surfaces of portion 17, but does not extend as far as appendix 8. When polymerized, resin 51 assumes a vitreous structure and becomes extremely hard to form a rigid connection 52 (Figure 3) of portion 17 of actuator 5 to base 23; and each electric connection 33, 39, 41 (Figures 4 and 5) is made by welding appendix 8 and contacts 20 and 25 perfectly rigidly to pins 34, 42 and 43.

When pins 34, 42, 43 are excited selectively by means of electric pulses, ceramic layers 9 and 11 of actuator 5 flex in one direction or the other to produce a predetermined deflection F of end 21 of actuator 5 with respect to the rest position. In Figure 3, the rest position of actuator 5 and the two excitation-induced positions are shown by dot-and-dash lines, the amount of deflection being exaggerated for the sake of clarity.

In use, known piezoelectric actuators 5 are subject to frequent failure of both ceramic layers 9 and 11 and electric connections 33, 39 and 41. Thorough testing of known actuators 5 conducted by the Applicant has shown various portions of actuators 5 to be subjected, in use, to severe stress. That is, connection 52 (Figure 3) has been found to produce reactions which tend to oppose excitation-induced deflection; and further reactions are produced at appendix 8 of central electrode 6 and at contacts 20 and 25 of lateral electrodes 12 and 13, owing to appendix 8 and contacts 20, 25 being flexed by electric excitation of actuator 5, but being rigidly connected to respective pins 34, 42, 43 by welded electric connections 33, 39, 41.

Failure rate has also been found to increase alongside an increase in the grain size and grain shear strength of the ceramic material of layers 9 and 11; and accelerations equivalent to excitation of the ceramic material have been found to vary widely with excitation frequency, and to be maximum at the resonance frequencies of actuator 5. Actuators 5 are normally excited at frequencies ranging from 0 to 200 Hz, but operating frequency is often below 100 Hz.

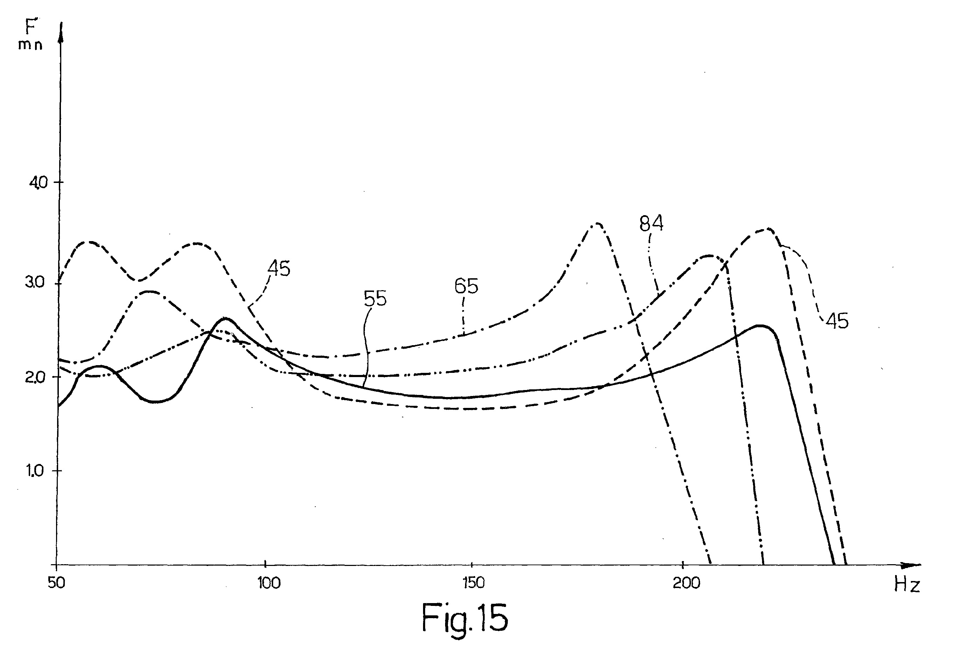

Figure 15 shows a graph 45 of deflection F of actuator 5, connected as shown in Figures 3-5, as a function of excitation frequency. As can be seen, deflection F is about 1.8 mm at frequencies between 120 and 180 Hz, but increases to over 3.3 mm at three resonance frequencies : two below 100 Hz and one over 220 Hz. As is known, stress increases with deflection F, so that deflection F at the above three resonance frequencies soon results in failure of actuator 5. Deflection F at 220 Hz resonance frequency, as shown by the sharply decreasing portion of graph 45, obviously does not apply to normal operation of actuators 5, whereas deflections F at the two lower resonance frequencies do, and are those which are responsible for the failure rate referred to above.

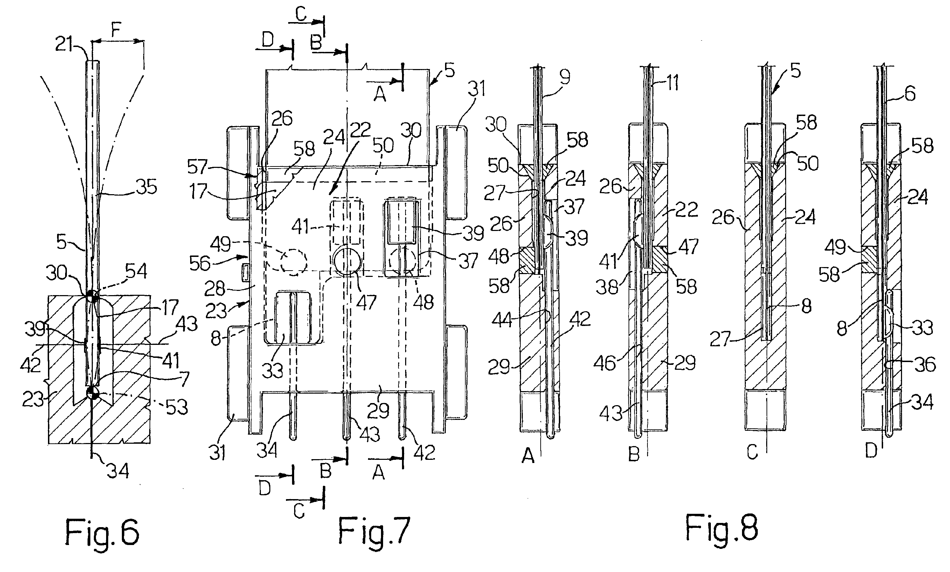

Tests conducted by the Applicant have shown that the reactions of the rigid constraints of ceramic layers 9 and 11 are greatly reduced by rendering flexible at least connection 22 between actuator 5 and base 23, or one of electric connections 33, 39, 41 between electrodes 6, 12, 13 and pins 34, 42, 43. According to a first embodiment of the invention, shown schematically in Figure 6, connection 52 in Figure 3 is therefore replaced with at least one hinge. More specifically, two hinges 53 and 54 are formed : hinge 53 being located at end 7 of actuator 5; and hinge 54 being located a given distance from hinge 53, i.e. at the end of connecting portion 17 defined by edges 30 of walls 24 and 26 of base 23.

Hinges 53 and 54 are formed by connecting actuator 5 to walls 24 and 26 by means of a polymerizable adhesive defined (Figures 7 and 8) by a urethane resin 58 - advantageously, Vitralit X 504 resin marketed by Collanti Parini. In Figures 7 and 8, the same actuator 5 as in Figures 1 and 2, and the same base 23 and same rigidly welded electric connections 33, 39, 41 as in Figures 4 and 5 are used.

Urethane resin 58 is only applied along two limited portions or transverse strips 56 and 57 of walls 24 and 26 respectively, and, being highly viscous prior to polymerization, can be applied in spots or very thin strips. Resin 58 is polymerized by ultraviolet rays, and, once polymerized, assumes a Shore D hardness (the unit by which the hardness of elastomeric materials is measured) of about 80-90, so that connection 22 is relatively flexible and limited to two thin strips 56 and 57.

In Figure 7, strip 56 is obtained by injecting a small amount of resin 58 through the three transversely aligned openings 47, 48 and 49, and is therefore defined by three connecting spots; and strip 57 is obtained by applying resin 58 to bevels 50 of edges 30 of walls 24 and 26. When actuator 5 in Figure 7 is excited, portion 17 between hinges 53 and 54 (Figure 6) is therefore free to flex and accompany the deflection of deflecting portion 35 of actuator 5, as shown by the dot-and-dash lines in Figure 6, thus eliminating the reactions generated on ceramic layers 9 and 11 by rigid connection 52 in Figures 3-5.

Tests show, as indicated by graph 55 in Figure 15, that deflection F of end 21 of actuator 5 is now about 1.9 mm, but extends beyond 220 Hz, and is considerably less than in graph 45 at the three resonance portions, thus reducing operating failure at low frequencies. Continuous excitation tests were also carried out, in which groups of actuators 5 were excited continuously at 70-80 Hz frequency for two 24-hour periods with a rest period in between. At the end of the test, the failure rate of actuators 5 connected to base 23 as shown in Figures 7 and 8 was found to be roughly 60% lower than that of actuators 5 connected in known manner as shown in Figures 4 and 5.

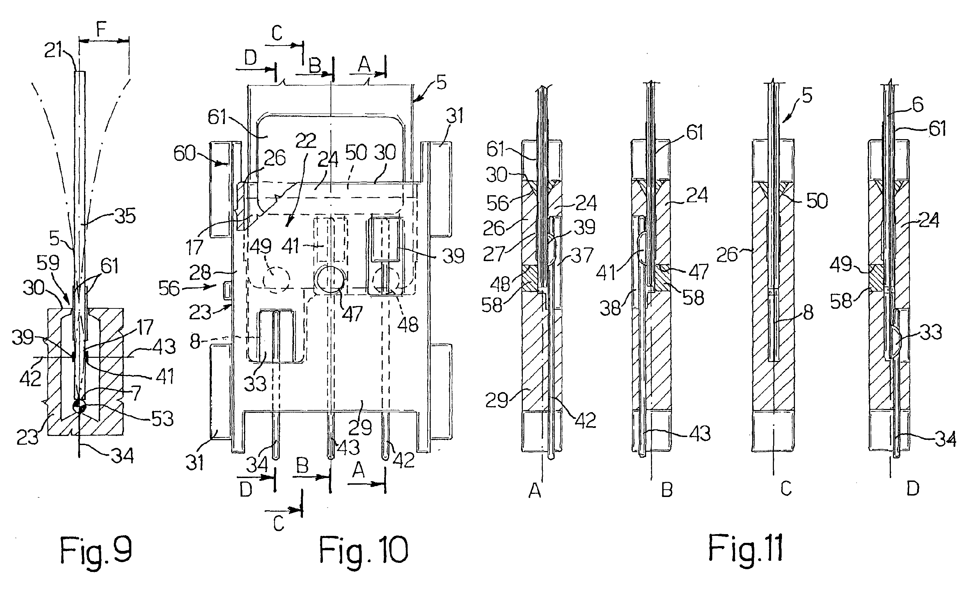

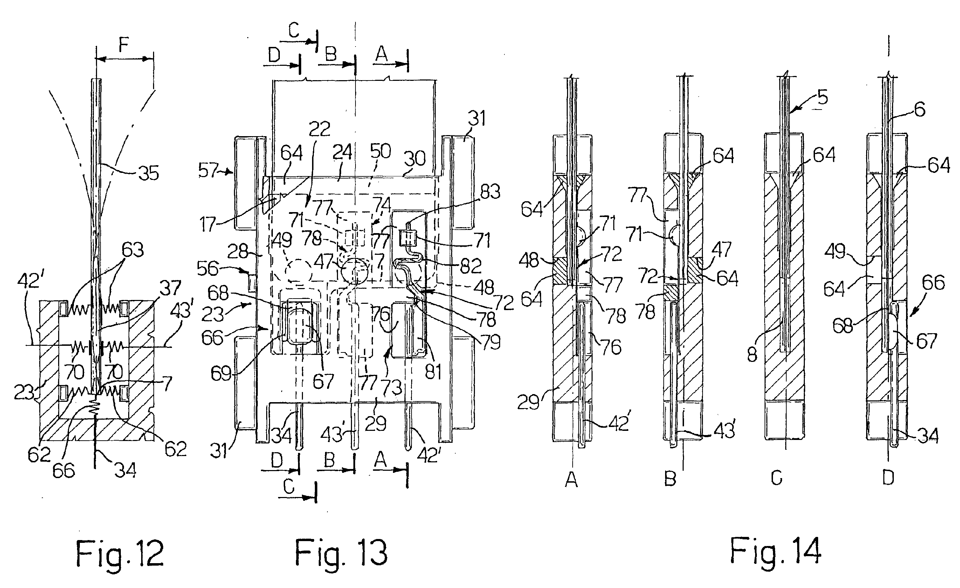

In a further embodiment of the invention, shown schematically in Figure 9, to connect portion 17 of actuator 5 to base 23, connection 52 in Figure 3 is replaced with a hinge 53 at end 7 of actuator 5, and with a slide 59 located a given distance from hinge 53, i.e. at the end of connecting portion 17 defined by edges 30 of walls 24 and 26 of base 23. More specifically, hinge 53 is formed by injecting urethane resin 58 into openings 47-49 (Figures 10 and 11) as in Figures 7 and 8; and slide 59 is formed by a label 61 defined by an adhesive-coated, roughly 80-micron-thick layer of polyester - advantageously, thermal-transfer polyester 7815 marketed by 3M.

Label 61 so formed is applied to a portion 60 of each film 14, 16 of insulating material, astride the end of portion 17 defined by edges 30 of walls 24 and 26 of base 23. Each label 61 slides along respective wall 24, 26 to form a sliding connection of actuator 5 close to edges 30 of walls 24 and 26, so that connection 22 of actuator 5 to base 23 by means of hinge 53 and slide 59 (Figure 9) allows portion 17 to flex, by bending or stretching, according to deflection or not of portion 35, as shown by the dot-and-dash lines in Figure 9. The end of connecting portion 17 defined by the edges of walls 24 and 26 therefore varies alongside deflection of portion 17, which thus has an additional degree of freedom to further reduce the reaction of base 23 on ceramic layers 9 and 11.

Tests show, as indicated by graph 65 in Figure 15, the elimination in this case of one of the low-frequency resonance portions. Deflection F of end 21 of actuator 5 is now about 2.2 mm and substantially extends from 80 to 180 Hz, while deflection at the one low-frequency resonance portion does not exceed 3 mm. Like actuators 5 in the previous case, excitation tests show the failure rate of actuator 5 connected to base 23 as shown in Figures 10 and 11 to be at least 90% lower than that of actuator 5 connected to base 23 in known manner as shown in Figures 4 and 5.

In a further embodiment of the invention, shown schematically in Figure 12, for connection 22 of portion 17 of actuator 5 to base 23, connection 52 in Figure 3 is replaced with two pairs of bearings 62 and 63 of flexible material : pair 62 being located at end 7 of actuator 5; and pair 63 being located a given distance from pair 62, i.e. at the end of portion 17 defined by edges 30 of walls 24 and 26. The material of bearings 62 and 63 is defined by a thixotropic gel, indicated 64 in Figures 13 and 14, which liquefies when subjected to mechanical stress, and returns to gel form when stress is removed, thus functioning like a retaining ring, as shown schematically in Figure 12.

Thixotropic gel 64 of bearings 62 and 63 may be defined by a silane-modified urethane resin - advantageously, Vitralit VBB-1 Gel marketed by Collanti Parini - which can be polymerized by ultraviolet rays and assumes, when polymerized, a Shore A hardness of 60-70. In the Figure 13 and 14 embodiment, bearings 62 are formed by filling openings 47-49 in walls 24 and 26 with thixotropic gel 64; and bearings 63 by filling with thixotropic gel 64 the gap between bevels 50 on walls 24, 26 and the outer surfaces of actuator 5.

To eliminate the reactions produced by the rigid electric connection of one or more of pins 34, 42, 43 to respective electrodes 6, 12, 13 of actuator 5, the rigid connection may be replaced with a flexible electric connection, either independently of flexible connection 22 of actuator 5 to base 23, or in addition to one of flexible connections 22, as shown in Figures 6, 9 and 12. In Figure 12, 66 indicates schematically a flexible electric connection of pin 34 to appendix 8 of central electrode 6.

With reference to the Figure 13 and 14 embodiment, flexible electric connection 66 is obtained by applying a corresponding weld spot 67 to a highly elastic portion 68 of appendix 8. More specifically, portion 68 is formed by making an inverted U-shaped cut 69 in appendix 8, so that portion 68 assumes the form of an elastic tongue 68. The reactions of pin 34 to flexure of appendix 8 of central electrode 6 are therefore absorbed by elastic tongue 68, as opposed to being transmitted to the rest of central electrode 6 of actuator 5.

In Figure 12, 70 indicates schematically a flexible electric connection between each lateral pin 42', 43' and the corresponding lateral electrode 12, 13 of actuator 5. With reference to the Figure 13 and 14 embodiment, each pin 42', 43' is shorter than the corresponding pin 42, 43 in Figures 4, 7 and 10; and electric connection 70 is obtained by reducing the dimension of the corresponding weld spot 71, and inserting between each pin 42', 43' and respective contact 20, 25 a highly elastic, electrically conducting, intermediate element 72 to which weld spot 71 is applied.

More specifically, each wall 24, 26 of base 23 has a rectangular window 73, 74 higher than windows 37, 38 in Figure 4. Each window 73, 74 comprises two portions 76 and 77 separated by a contoured appendix 78 which is engaged by end 7 of actuator 5, projects from one side of window 73, 74 (Figure 13), and extends at least half the width of window 73, 74, so that a passage 79 is formed between appendix 78 and the opposite side of window 73, 74.

The elastic conducting element is preferably defined by a roughly 0.2 mm thick copper bar 72 comprising a supporting portion 81 housed inside portion 76 of respective window 73, 74, and an elastic portion 82 housed in portion 77 of window 73, 74. Elastic portion 82 is in the form of a coil, and terminates in a straight end 82 to which weld spot 71 is applied.

Supporting portion 81 of bar 72 is clicked between pin 42', 43' and appendix 78 on one side, and the side of window 73, 74 opposite appendix 78 on the other; and electric contact between portion 81 and respective pin 42', 43' may be achieved by means of glue or another weld not shown in Figure 13. The reactions of pin 42', 43' to flexure of the corresponding ceramic layer 9, 11 are therefore also absorbed by elastic portion 82 of bar 72, as opposed to being transmitted to the corresponding layer 9, 11.

Tests show, as indicated by graph 84 in Figure 15, that, with actuator 5 connected as shown in Figures 12-14, i.e. with bearings 62 and 63 of flexible material and with flexible electric connections 66 and 70, deflection F of end 21 of actuator 5 is about 2 mm and extends substantially from 90 to 180 Hz; one of the low-frequency resonance portions is eliminated, as in the previous case; and deflection at the one low-frequency resonance portion does not exceed 2.5 mm. Like actuators 5 in the previous cases, burn-in excitation tests show the failure rate of actuator 5 connected as shown in Figures 13 and 14 to be about 99% lower that that of actuator 5 connected in known manner as shown in Figures 4 and 5.

The advantages, with respect to known systems, of the actuator 5 connecting system according to the invention will be clear from the foregoing description. In particular, the flexible connection 22 of portion 17 of actuator 5 to base 23 greatly reduces the reactions of base 23 to flexure of ceramic layers 9 and 11; the flexible electric connection 66, 70 of each pin 34, 42', 43' to corresponding electrode 6, 12, 13 of actuator 5 also reduces the reactions generated by the pins on electrodes 6, 12, 13; and, in each case, the in-service failure rate of actuators 5 is greatly reduced, thus greatly increasing the output of the machine fitted with actuators 5, and greatly reducing the cost of machine maintenance.

Clearly, changes may be made to the connecting system as described herein without, however, departing from the scope of the accompanying Claims. For example, changes may be made to the resins and other components of the flexible connections; the flexible connections may be formed by mechanical means, as opposed to adhesive materials; and connecting strip 56 at bottom end 7 of actuator 5 may be shaped differently from that formed by circular openings 47-49.

Moreover, label 61 in the Figure 10 and 11 embodiment may be applied to walls 24 and 26 of base 23, as opposed to portion 60 of portion 17; connection 22 may also be defined by a hinge 53 or 54, or a slide 59, and a pair of bearings 62 or 63; and bars 72 in Figure 13 may be replaced with strands of copper wire or other conducting material.

Piezoelectric actuators 5 mounted using the connecting system according to the invention may be used in industrial automation technology for a wide range of control or selection devices, e.g. on textile machines, motor vehicles and pneumatic devices, and can be operated in environments subject to severe vibration.

## Claims

1. A system for connecting a piezoelectric actuator (5) to a rigid supporting base (23), wherein said actuator (5) comprises a central electrode (6) having two opposite surfaces (3, 4), two layers of piezoelectric ceramic material (9, 11) fixed to said two surfaces (3, 4), and two lateral electrodes (12, 13) fixed to said layers of ceramic material (9, 11); comprising a connection (22) of said base (23) to a portion (17) of said actuator (5), said portion (17) including a region (8) of said central electrode (6) having a first electric connection (33, 66) to a central pin (34), and each of said lateral electrodes (12, 13) having a second electric connection (39, 41; 70) to a corresponding lateral pin (42, 43; 42', 43'); **characterized in that** at least one connection of said connections (22; 33, 39, 41; 66, 70) is flexible to reduce mechanical stress on said layers of ceramic material (9, 11) at said at least one connection (22; 33, 39, 41; 66, 70).

2. A connecting system as claimed in Claim 1, **characterized in that** said at least one connection (22) is that of said base (23) to said portion (17), and comprises at least a first hinge (53) enabling a corresponding rotation of said portion (17) with respect to said base (23).

3. A connecting system as claimed in Claim 2, **characterized in that** said first hinge (53) is located at one end (7) of said actuator (5); said at least one connection (22) comprising a second hinge (54) between said portion (17) and said base (23) and located a predetermined distance from said first hinge (53); said hinges (53, 54) being parallel to each other.

4. A connecting system as claimed in Claim 2 or 3, wherein said base (23) comprises two walls (24, 26) separated by a gap (27) for housing said portion (17); **characterized in that** said hinge (53, 54) is formed by means of urethane resin (58) applied to a corresponding transverse strip (56, 57) between said portion (17) and said walls (24, 26).

5. A connecting system as claimed in Claim 4, wherein each of said walls (24, 26) comprises at least one opening (47-49) on one of said transverse strips (56, 57), and a bevel (50) on an edge (30) of each of said walls (24, 26); **characterized in that** said hinges (53, 54) are obtained by injecting said urethane resin (58) into said openings (47-49) and into said bevels (50).

6. A connecting system as claimed in Claim 2, **characterized in that** said first hinge (53) is located at one end (7) of said actuator (5); said at least one connection (22) comprising an element (59) permitting a sliding movement between a strip (60) of said portion (17) and said base (23); said element (59) being located a predetermined distance from said first hinge (53).

7. A connecting system as claimed in Claim 6, **characterized in that** said element (59) is defined by a label (61) fixed to each side of said strip (60) of said portion (17), or to each wall (24, 26) of said base (23).

8. A connecting system as claimed in Claim 7, **characterized in that** said label (61) is defined by a layer of sliding polyester material having a layer of glue.

9. A connecting system as claimed in Claim 1, **characterized in that** said at least one connection (22) comprises two pairs of flexible bearings (62, 63); said pairs (62, 63) being located on two transverse strips (56, 57) between said portion (17) and said walls (24, 26) of said base (23); and said pairs (62, 63) being parallel to each other and located a predetermined distance apart.

10. A connecting system as claimed in Claim 9, **characterized in that** said bearings (62, 63) are defined by a thixotropic gel (64) on said transverse strips (56, 57).

11. A connecting system as claimed in Claim 10, **characterized in that** said thixotropic gel (64) is defined by silane-modified urethane.

12. A connecting system as claimed in Claim 10 or 11, wherein said base (23) comprises two walls (24, 26) separated by a gap (27) for housing said portion (17); and wherein each of said walls (24, 26) comprises at least one opening (47-49) on one of said transverse strips (56, 57); the other of said transverse strips (56, 57) being defined by a bevel (50) on an edge (30) of each of said walls (24, 26); **characterized in that** said bearings (62, 63) are formed by injecting said thixotropic gel (64) into said openings (47-49) and into said bevels (50).

13. A connecting system as claimed in one of the foregoing Claims, **characterized in that** said first electric connection (66) is formed on an elastic element (68) formed in said region (8) of said central electrode (6); said region (8) being without said layers of ceramic material (9, 11).

14. A connecting system as claimed in Claim 13, **characterized in that** said elastic element is in the form of an elastic tongue (68) formed by making an inverted U-shaped cut (69) in said region (8).

15. A connecting system as claimed in one of the foregoing Claims, **characterized in that** at least one of said second electric connections (70) is defined by a further elastic element (72) made of highly conductive material and interposed between one of said lateral electrodes (12, 13) and the corresponding lateral pin (42', 43').

16. A connecting system as claimed in Claim 15, **characterized in that** said further elastic element is defined by a bar (72) having a coil-shaped portion (82) welded to said lateral electrode (12, 13).

17. A connecting system as claimed in Claim 16, **characterized in that** said bar (72) also comprises an anchoring portion (81) which clicks inside a seat (76) in one of said walls (24, 26) as to engage the corresponding lateral pin (42', 43').

18. A connecting system as claimed in Claim 17, **characterized in that** said seat is defined by a portion (76) of a rectangular window (73, 74); said coil-shaped portion (82) being housed in another portion (77) of said window (73, 74); and said portions (76, 77) being separated by an appendix (78) which is engaged by said end (7) of the actuator (5).
